# EUROPEAN PATENT APPLICATION

(11) **EP 4 844 885 A1**
(43) Date of publication of application: **25.11.2026**
(21) Application number: 25913393.2
(22) Date of filing: 24.09.2025
(51) Int. Cl.: H01M 10/42, H01M 10/48, G01R 31/382, H02J 7/00, B60L 58/10

(54) **WAKE-UP DEVICE OF BATTERY MANAGEMENT SYSTEM AND BATTERY SYSTEM INCLUDING SAME**

(30) Priority: 26.12.2024 KR 20240197727; 10.04.2025 KR 20250046657
(71) Applicant: LG Energy Solution, Ltd., Seoul 07335 (KR)
(72) Inventor: KIM, Jeong Wook, Daejeon 34122 (KR)
(74) Representative: Plasseraud IP
(86) International application number: PCT/KR2025/014972
(87) International publication number: WO 2026/141867

(57) **Abstract**

A wake-up apparatus for waking up a main control unit (MCU) of a battery management system configured to manage a plurality of battery cells may include a power supply device configured to receive a first power signal from an auxiliary voltage source used for starting a vehicle through a second relay of the vehicle. The power supply device may be configured to provide a second power signal for an operation of the MCU to the MCU using the first power signal. The wake-up apparatus may further include a wake-up control circuit configured to receive the first power signal from the auxiliary voltage source through a first relay of the vehicle in response to a key-on signal of the vehicle. The wake-up control circuit may be further configured to drive the second relay to an on state in response to the first power signal.

## Description

### [Technical Field]

### CROSS-REFERENCE TO RELATED APPLICATION

This application claims priority to and the benefit of Korean Patent Application No. 10-2024-0197727 filed on December 26, 2024, and Korean Patent Application No. 10-2025-0046657 filed on April 10, 2025 with the Korean Intellectual Property Office, the entire contents of which are incorporated herein by reference.

The present disclosure relates to a wake-up apparatus of a battery management system and a battery system including the same.

### [Background Art]

Electric vehicles may be driven using an electric motor and use a battery system, which is a high-voltage power source, to drive the electric motor.

The battery system includes a plurality of battery cells and a Battery Management System (BMS). The BMS monitors and controls the state of the plurality of battery cells.

The BMS may operate by receiving power from an internal battery system or external device (e.g., a vehicle). When the BMS receives power from the battery cells of the battery system, it is always in a power-on state and thus consumes power from the battery system even in specific situations, such as when the ignition of the vehicle is turned off. Therefore, in certain situations where the BMS does not need to operate, it is necessary to completely cut off the power supply to the BMS and set the BMS to a shutdown mode to reduce the power consumption of the battery system.

### [Disclosure]

### [Technical Problem]

An embodiment of the present disclosure is intended to provide a wake-up apparatus for a battery management system and a battery system including the same, which can set the battery management system to a shutdown mode.

### [Technical Solution]

According to an embodiment, a wake-up apparatus for waking up a Main Control Unit (MCU) of a battery management system configured to manage a plurality of battery cells may be provided. The wake-up apparatus may include a power supply device configured to receive a first power signal from an auxiliary voltage source used for starting a vehicle through a second relay of the vehicle, and provide a second power signal for an operation of the MCU to the MCU using the first power signal, and a wake-up control circuit configured to receive the first power signal from the auxiliary voltage source through a first relay of the vehicle in response to a key-on signal of the vehicle, and drive the second relay to an on state in response to the first power signal.

The MCU may be configured to generate a latch signal of an enable level in response to an on level of the second power signal, and the wake-up control circuit may be configured to drive the second relay to the on state in response to the latch signal of the enable level.

The MCU may be configured to generate a latch signal of a disable level after a set time has elapsed from a time point of receiving a key-off signal of the vehicle, and the wake-up control circuit may be configured to drive the second relay to an off state in response to the latch signal of the disable level.

The first relay may include a first switch having one end connected to the auxiliary voltage source and a first coil having one end receiving the key-on signal or key-off signal and another end connected to ground. The second relay may include a second switch having one end connected to the auxiliary voltage source and a second coil having one end connected to the auxiliary voltage source. The wake-up control circuit may include a first transistor including a control terminal to which the first power signal is input through the first switch of the first relay, a first terminal connected to ground. A second terminal connected to another end of the second coil of the second relay, and the power supply device may be configured to connect to another end of the second switch.

The MCU may be configured to generate the latch signal of the enable level in response to the on level of the second power signal and generate the latch signal of the disable level after a set time has elapsed from a time point of receiving the key-off signal of the vehicle. The wake-up control circuit may further comprise a second transistor including a control terminal to which the latch signal is input, a first terminal connected to ground, and a second terminal connected to the another end of the second coil of the second relay.

The wake-up control circuit may be configured to drive the second relay to an off state through the second transistor, which is turned off in response to the latch signal of the disable level, and cut off the first power signal provided from the auxiliary voltage source to the power supply device.

The wake-up control circuit may be configured to control an on or off state of the second relay based on a signal generated through a logical operation of an MCU state signal output from a watchdog timer that monitors a state of the MCU and a latch signal of an enable level output from the MCU in response to the second power signal.

The MCU periodically may transmit a kick signal to the watchdog timer. The watchdog timer may be configured to generate an MCU state signal of a high level in response to the kick signal received from the MCU, and generate an MCU state signal of a low level if the kick signal is not received from the MCU within a set period.

The MCU may be configured to generate a latch signal of a disable level after a set time has elapsed from a time point of receiving a key-off signal of the vehicle.

The logical operation may include a logical AND operation.

The first relay may include a first switch having one end connected to the auxiliary voltage source and a first coil having one end receiving the key-on signal or key-off signal and another end connected to ground. The second relay may include a second switch having one end connected to the auxiliary voltage source and a second coil having one end connected to the auxiliary voltage source. The wake-up control circuit may include a first transistor including a control terminal to which the first power signal is input through the first switch of the first relay, a first terminal connected to ground, and a second terminal connected to another end of the second coil of the second relay. The power supply device may be connected to another end of the second switch.

The wake-up control circuit may further comprise a second transistor including a control terminal to which a signal generated through the logical operation is input, a first terminal connected to ground, and a second terminal connected to the another end of the second coil of the second relay.

According to another embodiment, a battery system mounted in a vehicle may be provided. The battery system may include a battery pack including a plurality of battery cells, and a battery management system managing the battery pack. The battery management system may include a main control unit (MCU) monitoring a state of the plurality of battery cells, a wake-up control circuit receiving a first power signal from an auxiliary voltage source used for starting the vehicle through a first relay of the vehicle in response to a key-on signal of the vehicle to drive a second relay of the vehicle to an on state, and a power supply device receiving the first power signal from the auxiliary voltage source through the second relay, and providing a second power signal for an operation of the MCU to the MCU using the first power signal.

The MCU may be configured to generate a latch signal of an enable level in response to an on level of the second power signal. The wake-up control circuit may be configured to drive the second relay to the on state in response to the latch signal of the enable level.

The MCU may be configured to generate a latch signal of a disable level after a set time has elapsed from a time point of receiving a key-off signal of the vehicle. The wake-up control circuit may be configured to drive the second relay to an off state in response to the latch signal of the disable level.

The battery management system may further comprise a watchdog timer configured to receive a kick signal periodically output from the MCU, to monitor a state of the MCU based on the received kick signal, and to generate an MCU state signal representing the state of the MCU. The wake-up control circuit may be configured to control an on or off state of the second relay through a logical operation of the MCU state signal and a latch signal output from the MCU. The MCU may be configured to generate a latch signal of an enable level in response to the second power signal.

The watchdog timer may be configured to generate an MCU state signal of a high level in response to the received kick signal, and to generate an MCU state signal of a low level if the kick signal is not received from the MCU within a set period. The MCU may be configured to generate a latch signal of a disable level after a set time has elapsed from a time point of receiving a key-off signal of the vehicle.

The wake-up control circuit may be configured to drive the second relay to an off state in response to the MCU state signal of the low level, and to drive the second relay to an off state in response to the latch signal of the disable level when the MCU state signal is at a high level.

The first relay may include a first switch having one end connected to the auxiliary voltage source and a first coil having one end receiving the key-on signal or key-off signal and another end connected to ground. The second relay may include a second switch having one end connected to the auxiliary voltage source and a second coil having one end connected to the auxiliary voltage source. The wake-up control circuit may include a first transistor including a control terminal to which the first power signal is input through the first switch of the first relay, a first terminal connected to ground, and a second terminal connected to another end of the second coil of the second relay. The power supply device may be configured to connect to another end of the second switch.

The battery management system may further comprise an AND gate for performing a logical AND operation on the MCU state signal and the latch signal and outputting a result. The wake-up control circuit may further comprise a second transistor including a control terminal to which an output signal of the AND gate is input, a first terminal connected to ground, and a second terminal connected to the another end of the second coil of the second relay.

### [Advantageous Effects]

According to at least one of the embodiments, the MCU of the battery management system may be woken up by using an auxiliary voltage source of an external device, and the MCU may be set to a shutdown mode by disconnecting the MCU of the battery management system from the auxiliary voltage source of the external device, thereby reducing the power consumption of the battery system.

### [Description of the Drawings]

FIG. 1 is a diagram showing an example of a battery system according to an embodiment.
FIG. 2 is a diagram showing the wake-up apparatus and the external device shown in FIG. 1 in detail.
FIG. 3 is a diagram showing the wake-up control circuit shown in FIG. 2 in detail.
FIGS. 4 to 6 are diagrams for explaining the operation process of a wake-up apparatus according to an embodiment, respectively.
FIG. 7 is a diagram showing a switching timing chart of a wake-up control circuit according to an embodiment.
FIG. 8 is a diagram showing a wake-up apparatus according to another embodiment.

### [Mode for Invention]

Hereinafter, embodiments will be described in detail with reference to the accompanying drawings so that those skilled in the art to which the present invention pertains can easily implement them. However, they may be implemented in various different forms and are not limited to the embodiments described herein. The drawings and description are to be regarded as illustrative in nature and not restrictive. Like reference numerals designate like elements throughout the specification. In the flowchart described with reference to the drawings in this specification, the order of operations may be changed, several operations may be merged, some operations may be divided, and specific operations may not be performed.

Throughout the specification and claims, if a part is referred to "include" a certain element, it may mean that it may further include other elements rather than exclude other elements, unless specifically indicated otherwise.

In addition, expressions described in the singular may be interpreted in the singular or plural unless explicit expressions such as "one" or "single" are used.

In addition, terms including an ordinal number, such as first, second, etc., may be used to describe various elements, but the elements are not limited by the terms. The above terms are used only for the purpose of distinguishing one element from another element. For example, without departing from the scope of the present disclosure, a first element may be referred to as a second element, and similarly, a second element may be referred to as a first element.

Furthermore, if a component is referred to be "connected" with another component, it includes not only the case where two components are "directly connected" but also the case where two components are "indirectly or non-contactedly connected" with another component interposed therebetween, or the case where two components are "electrically connected." On the other hand, if an element is referred to as "directly connected" to another element, it should be understood that no other element exists in the middle.

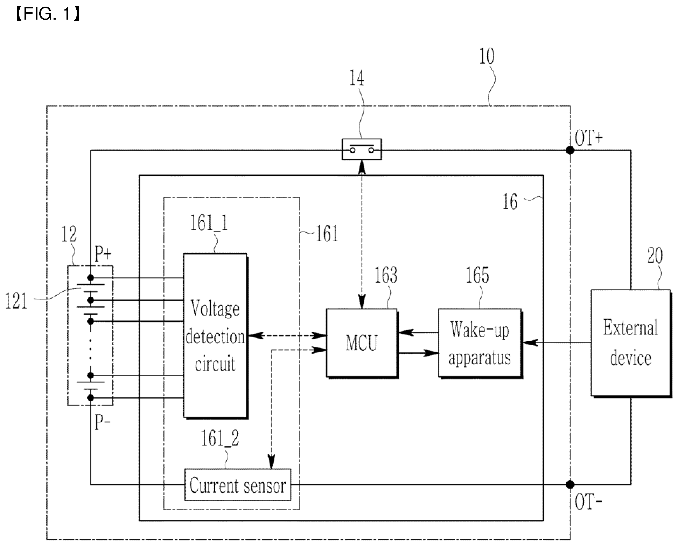

FIG. 1 is a diagram illustrating an example of a battery system according to an embodiment.

Referring to FIG. 1, a battery system 10 may have a structure connected to an external device 20 through a connection terminal OT+ and a connection terminal OT-.

In some embodiments, when the external device 20 is a load, the battery system 10 may operate as a power source supplying power to the load and be discharged. When the external device 20 is a charger, the battery system 10 may be charged by receiving external power through the charger. In some embodiments, the external device 20 operating as a load may be, for example, an electronic device, a means of transportation, or an energy storage system (ESS), and the means of transportation may be a vehicle such as an electric vehicle, a hybrid vehicle, or a smart mobility device.

The battery system 10 may include a battery pack 12, a relay 14, and a battery management system (BMS) 16.

The battery pack 12 includes a plurality of battery cells 121 connected in series. The plurality of battery cells 121 are capable of charging and discharging, and may be, for example, lithium-ion cells. The number of the plurality of battery cells constituting the battery pack 12 and their connection relationship may be designed according to the voltage and capacity required for the battery pack 12.

The relay 14 may provide a current path during charging and discharging of the battery pack 12. The relay 14 may be connected between the positive terminal P+ of the battery pack 12 and the connection terminal OT+ of the battery system 10. When the relay 14 is closed, the positive terminal P+ of the battery pack 12 may be electrically connected to the connection terminal OT+ of the battery system 10.

In some embodiments, a relay 14 may be connected between the negative terminal P- of the battery pack 12 and the connection terminal OT- of the battery system 10.

The relay 14 may be turned on/off in response to a control signal from the BMS 16. The relay 14 may be a mechanical contactor turned on/off by the magnetic force of a coil, or a semiconductor switch such as a field effect transistor (FET).

The BMS 16 may include a sensing circuit 161, a main control unit (MCU) 163, and a wake-up apparatus 165.

The sensing circuit 161 may be configured to acquire state parameters of the plurality of battery cells 121. The state parameters may include the voltages of the battery cells 121 and the voltage and current of the battery pack 12.

The sensing circuit 161 may include a voltage detection circuit 161_1 and a current sensor 161_2.

The voltage detection circuit 161_1 is connected to the positive and negative terminals of each of the plurality of battery cells 121 included in the battery pack 12 to measure the cell voltage across each battery cell 121 and transfer the measured cell voltages to the MCU 163.

The current sensor 161_2 may be connected in series between the negative terminal P- of the battery pack 12 and the connection terminal OT-. Unlike shown in FIG. 1, the current sensor 161_2 may be connected in series between the positive terminal P+ of the battery pack 12 and the connection terminal OT+. The current sensor 161_2 measures the current flowing through the battery pack 12 and transfers the measured current to the MCU 163.

The MCU 163 may be set to a shutdown mode or switch from the shutdown mode to a normal mode in response to a control signal of the external device 20. The shutdown mode may represent a state in which power supply to the MCU 163 is completely cut off, and unnecessary power may not be consumed in the shutdown mode. The normal mode may represent a state in which power is supplied to the MCU 163 and the MCU 163 is woken up.

In some embodiments, when the external device 20 is a means of transportation, the control signal may be an ignition signal, which is a key-on/key-off signal. In the following description, it is assumed that the external device 20 is a vehicle.

In some embodiments, when the external device 20 is a charger, the control signal may be a charge start signal.

The MCU 163 may control and manage the overall operation of the battery system 10 in the normal mode. The MCU 163 may receive cell voltages from the voltage detection circuit 161_1 and the current of the battery pack 12 from the current sensor 161_2, and monitor the overall state of the battery pack 12 and the battery cells 121 included in the battery pack 12 using the received data. In addition, the MCU 163 may control charging/discharging and perform cell balancing operations based on the overall state of the battery pack 12 and the battery cells 121.

The MCU 163 may be implemented in terms of hardware using at least one of an application specific integrated circuit (ASIC), a digital signal processor (DSP), a digital signal processing device (DSPD), a programmable logic device (PLD), a field programmable gate array (FPGA), a microprocessor, an application processor (AP), a central processing unit (CPU), a graphic processing unit (GPU), or other electrical units for performing functions.

The wake-up apparatus 165 may receive power from the external device 20 and provide a power signal to the MCU 163 from the power supplied from the external device 20 or cut off the power signal provided to the MCU 163, based on the control signal of the external device 20.

The wake-up apparatus 165 may wake up the MCU 163 by providing a power signal to the MCU 163. Also, the wake-up apparatus 165 may set the MCU 163 to a shutdown mode by cutting off the power signal to the MCU 163.

As such, when waking up the MCU 163, the wake-up apparatus 165 does not use power from the battery pack 12 but provides the power signal from the power of the external device 20, thereby reducing power consumption of the battery pack 12. Furthermore, by cutting off the power signal to set the MCU 163 to shutdown mode when necessary, unnecessary power consumption of the MCU 163 may be reduced.

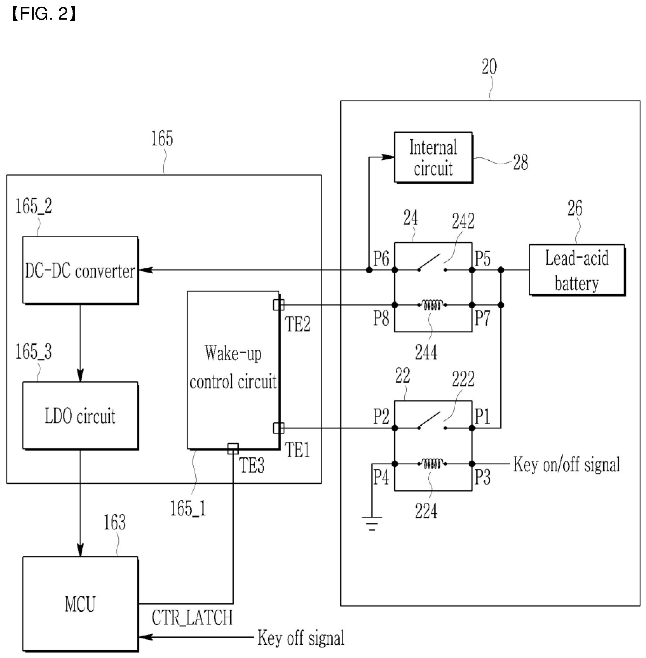

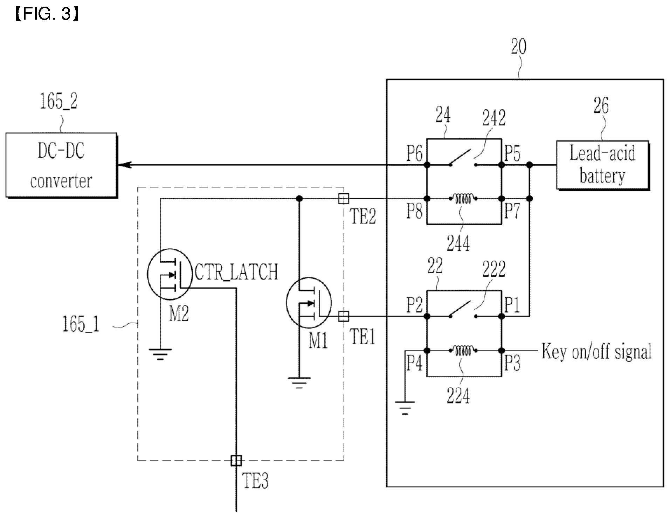

FIG. 2 is a diagram showing the wake-up apparatus and the external device shown in FIG. 1 in detail, and FIG. 3 is a diagram showing the wake-up control circuit shown in FIG. 2 in detail.

Referring to FIG. 2, the external device 20 may include relays 22 and 24 and a lead-acid battery 26. For convenience, the relay 22 is referred to as a first relay 22, and the relay 24 is referred to as a second relay 24.

The external device 20 may further include an internal circuit 28.

The first relay 22 and the second relay 24 may have a 4-pin structure.

The first relay 22 may include a first switch 222 and a first coil 224. The first switch 222 may be connected between a first pin P1 and a second pin P2. The first coil 224 may be connected between a third pin P3 and a fourth pin P4. The first pin P1 may be connected to the lead-acid battery 26. The second pin P2 may be connected to the wake-up apparatus 165. A key-on/key-off signal, which is a control signal, may be input to the third pin P3. The fourth pin P4 may be connected to ground. Current flows through the first coil 224 of the first relay 22 by the key-on signal, and current may not flow through the first coil 224 by the key-off signal. When current flows through the first coil 224, the first switch 222 is closed and the first relay 22 enters an on state. If no current flows, the first switch 222 opens and the first relay 22 enters an off state.

The second relay 24 may include a second switch 242 and a second coil 244. The second switch 242 may be connected between a fifth pin P5 and a sixth pin P6. The second coil 244 may be connected between a seventh pin P7 and an eighth pin P8. The fifth pin P5 and the seventh pin P7 are connected to the lead-acid battery 26. The sixth pin P6 may be connected to the DC-DC converter 165_2 of the wake-up apparatus 165, and the eighth pin P8 may be connected to the wake-up control circuit 165_1 of the wake-up apparatus 165. When current flows through the second coil 244, the second switch 242 is closed and the second relay 24 enters an on state. If no current flows, the second switch 242 opens and the second relay 24 enters an off state.

In some embodiments, a PhotoMOS relay may be used as the first and second relays 22 and 24.

The lead-acid battery 26 supplies power to the main electrical systems of the external device 20. According to the embodiment, the lead-acid battery 26 may be an auxiliary voltage source used for starting the vehicle. The lead-acid battery 26 may provide, for example, 12V power. Instead of a lead-acid battery 26, other batteries such as lithium-ion batteries may be used.

The internal circuit 28 may operate by receiving power from the lead-acid battery 26 through the second relay 24.

The wake-up apparatus 165 may include a wake-up control circuit 165_1, a DC-DC converter 165_2, and a low dropout (LDO) circuit 165_3. The DC-DC converter 165_2 and the LDO circuit 165_3 may be power supply devices that supply power to the MCU 163.

Referring to FIGS. 2 and 3 together, the wake-up control circuit 165_1 has first to third terminals TE1, TE2, and TE3 and may include transistors M1 and M2. For convenience, transistor M1 is called a first transistor M1, and transistor M2 is called a second transistor M2. Although FIG. 3 shows M1 and M2 as n-type, they may be replaced with p-type. Also, although M1 and M2 are shown as FETs, they may be implemented as various transistors such as heterojunction bipolar transistor (HBT), bipolar junction transistor (BJT), or insulated gate bipolar transistor (IGBT).

The gate of the first transistor M1 may be connected to the second pin P2 of the first relay 22 through the first terminal TE1, the drain of the first transistor M1 may be connected to the eighth pin P8 of the second relay 24 through the second terminal TE2, and the source of the first transistor M1 may be connected to ground. The gate of the first transistor M1 may be called a control terminal, and the drain and source of the first transistor M1 may be referred to as a first terminal or a second terminal.

The first transistor M1 may be turned on in response to a key-on signal received from the third pin P3 of the first relay 22, and the eighth pin P8 of the second relay 24 may be connected to ground by the turning on of the first transistor M1. That is, by the turn-on of the first transistor M1, current flows through the second coil 244 of the second relay 24, and accordingly, the second switch 242 of the second relay 24 is closed and the second relay 24 enters an on state.

Meanwhile, the first transistor M1 may be turned off in response to a key-off signal received from the third pin P3 of the first relay 22, and the eighth pin P8 of the second relay 24 becomes a floating state by the turning off of the first transistor M1. That is, by the turn-off of the first transistor M1, current does not flow through the second coil 244 of the second relay 24, and accordingly, the second switch 242 of the second relay 24 is opened and the second relay 24 enters an off state.

The gate of the second transistor M2 may be connected to the third terminal TE3, through which a latch signal CTR_LATCH may be input from the MCU 163. The drain of the second transistor M2 may be connected to the eighth pin P8 of the second relay 24, and the source of the second transistor M2 may be connected to ground. The gate of the second transistor M2 may be called a control terminal, and the drain and source of the second transistor M2 may be referred to as a first terminal or a second terminal.

The wake-up control circuit 165_1 may drive the second relay 24 into an on state by connecting the eighth pin P8 of the second relay 24 to ground in response to the key-on signal through the first relay 22, thereby allowing current to flow through the second coil 244.

The DC-DC converter 165_2 may be connected to the sixth pin P6 of the second relay 24. The DC-DC converter 165_2 may receive a power signal from the lead-acid battery 26 when the second relay 24 enters an on state.

Upon receiving the power signal, the DC-DC converter 165_2 generates a driving voltage for the LDO circuit 165_3 using the voltage of the power signal and provides the driving voltage to the LDO circuit 165_3.

The LDO circuit 165_3 generates a voltage for operating the MCU 163 using the driving voltage received from the DC-DC converter 165_2 and provides the power signal of the generated voltage level to the MCU 163.

The MCU 163 wakes up upon receiving the power signal, latches an on level (high level) of the power signal, and generates a latch signal CTR_LATCH of an enable-level (high level). Also, the MCU 163 receives the key-off signal and generates a latch signal CTR_LATCH of a disable level (low level) after a predetermined time has elapsed from the time point of receiving the key-off signal.

The MCU 163 may output the latch signal CTR_LATCH to the gate of the second transistor M2 through the third terminal TE3 of the wake-up control circuit 165_1. That is, the latch signal CTR_LATCH generated by the MCU 163 may be a signal input to the gate of the second transistor M2.

In some embodiments, the MCU 163 may receive key-on/key-off signals through wired/wireless communication means set with the external device 20.

In some embodiments, the MCU 163 may receive the key-off signal through the wake-up apparatus 165. When a key-off signal occurs, the first relay 22 is turned off, so the wake-up control circuit 165_1 does not receive any signal through the first relay 22. At this time, the wake-up control circuit 165_1 recognizes the key-off signal and provides a signal corresponding to the key-off signal to the MCU 163.

The second transistor M2 may be turned on in response to the latch signal CTR_LATCH of the enable-level, the eighth pin P8 of the second relay 24 may be connected to ground by the turn-on of the second transistor M2. That is, by the turn-on of the second transistor M2, current flows through the second coil 244 of the second relay 24, and accordingly, the second switch 242 of the second relay 24 is closed and the second relay 24 enters an on state.

That is, even if the first transistor M1 is turned off in response to the key-off signal, the latch signal CTR_LATCH maintains the enable level during a predetermined period of time from the time point of receiving the key-off signal. Therefore, the second relay 24 may maintain the on state during the predetermined period from the time point of receiving the key-off signal, and the power signal may be provided to the MCU 163 during the predetermined period.

On the other hand, when the latch signal CTR_LATCH becomes a disable level after the predetermined period of time has elapsed in a state where the first transistor M1 is turned off in response to the key-off signal, the second transistor M2 is turned off, and accordingly, the second relay 24 enters an off state, and the MCU 163 may be set to a shutdown mode.

As described above, the wake-up control circuit 165_1 may receive a power signal from the lead-acid battery 26 through the first relay 22 in response to a key-on signal and drive the second relay 24 to an on state in response to the received power signal. In addition, the wake-up control circuit 165_1 may maintain the second relay 24 in the on state in response to a latch signal CTR_LATCH of an enable level while the first transistor M1 is turned off by the first relay 22 operating in an off state in response to a key-off signal, and may drive the second relay 24 to an off state in response to a latch signal CTR_LATCH of a disable-level.

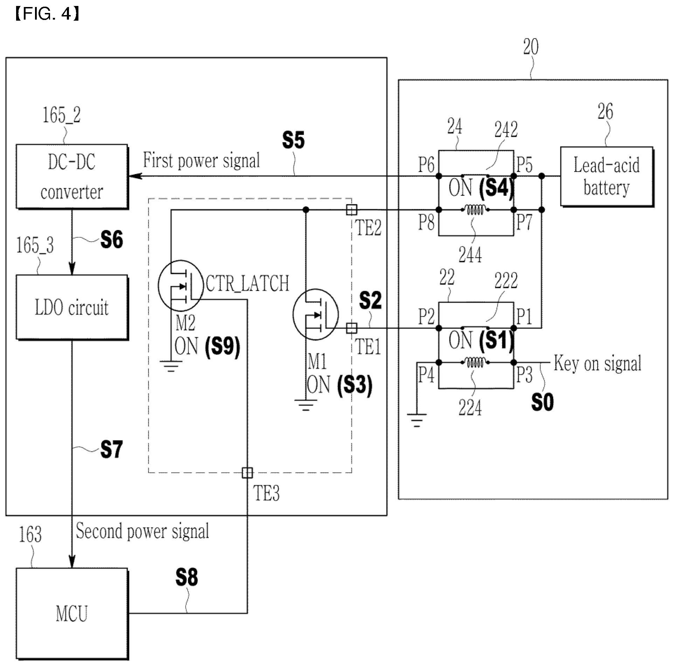

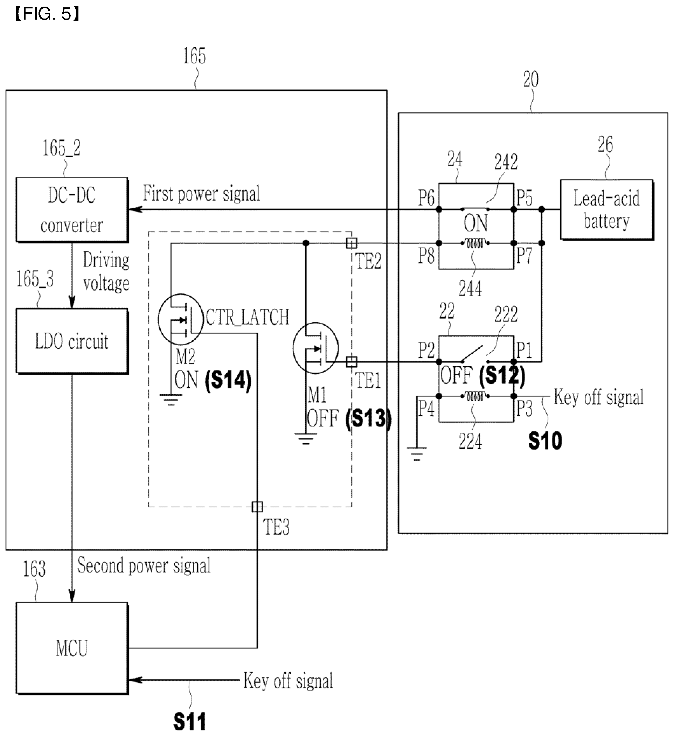

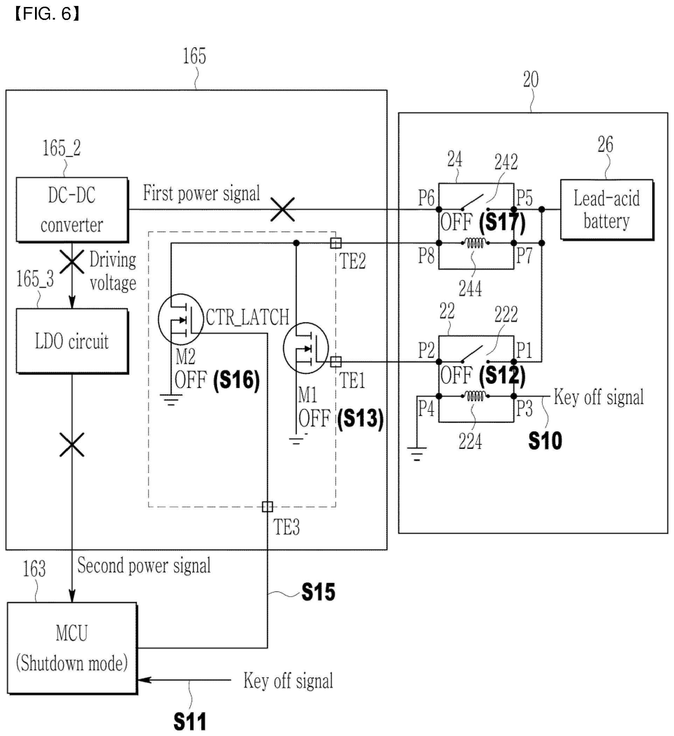

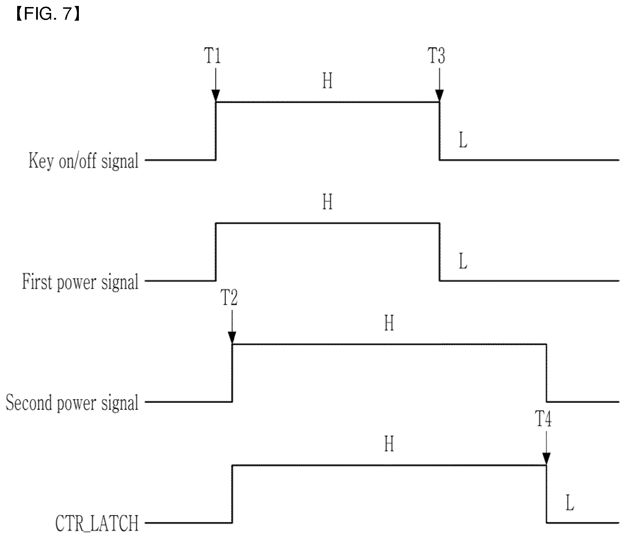

FIGS. 4 to 6 are diagrams for explaining the operation process of the wake-up apparatus according to an embodiment, respectively. FIG. 4 is a diagram for explaining the operation process of the wake-up apparatus in response to a key-on signal, FIG. 5 is a diagram for explaining the operation process of the wake-up apparatus in response to a key-off signal, and FIG. 6 is a diagram for explaining the operation process of the wake-up apparatus in response to a latch signal of a disable level. FIG. 7 is a diagram showing a switching timing of the wake-up control circuit according to an embodiment.

In FIG. 7, a high level H in the key-on/key-off signal may represent a key-on signal, and a low level L in the key-on/key-off signal may represent a key-off signal. The first power signal may be a signal input to the gate of the first transistor M1. The high level H of the first power signal may be a voltage supplied from the lead-acid battery 26, and the low level L of the first power signal may represent a state in which the gate of the first transistor M1 is floating. The second power signal is a power signal output from the wake-up apparatus 165 to the MCU 163 for the operation of the MCU 163. The high level H of the second power signal may be a voltage level required for the operation of the MCU 163, and the low level L of the second power signal may represent a state in which the power supply to the MCU 163 is completely cut off. The latch signal CTR_LATCH may be a signal input to the gate of the second transistor M2.

Referring to FIGS. 4 and 7, when a key-on signal occurs at time T1 (S0), current flows through the first coil 224 of the first relay 22, and the first switch 222 of the first relay 22 is closed. Accordingly, the first relay 22 enters an on state (S1).

When the first relay 22 is in the on state, the first power signal from the lead-acid battery 26 is input to the gate of the first transistor M1 (S2), and accordingly, the first transistor M1 may be turned on (S3).

When the first transistor M1 is turned on, current flows through the second coil 244 of the second relay 24, and the second switch 242 of the second relay 24 is closed. Accordingly, the second relay 24 enters an on state (S4).

When the second relay 24 is in the on state, the first power signal from the lead-acid battery 26 may be input to the DC-DC converter 165_2 (S5).

The DC-DC converter 165_2 generates a driving voltage for the LDO circuit 165_3 using the voltage of the first power signal from the lead-acid battery 26 and provides the driving voltage to the LDO circuit 165_3 (S6).

The LDO circuit 165_3 generates a voltage for the operation of the MCU 163 using the driving voltage received from the DC-DC converter 165_2 and provides a second power signal of the generated voltage level H to the MCU 163 (S7).

At time T2, which is after a predetermined delay time from time T1, the MCU 163 may receive the second power signal.

At time T2, the MCU 163 wakes up and generates a latch signal CTR_LATCH having an enable level H by latching a high level H of the second power signal. The MCU 163 outputs the latch signal CTR_LATCH of the enable level H to the gate of the second transistor M2 of the wake-up control circuit 165_1 (S8).

The second transistor M2 may be turned on in response to the latch signal CTR_LATCH of the enable level H (S9), and the eighth pin P8 of the second relay 24 may be connected to ground by the turning on of the second transistor M2.

Next, referring to FIGS. 5 and 7, at time T3, a key-off signal may be input to the first coil 224 of the first relay 22 (S10). Additionally, the key-off signal may be transmitted to the MCU 163 (S11).

Then, current does not flow through the first coil 224 of the first relay 22, and the first switch 222 of the first relay 22 is opened. Accordingly, the first relay 22 enters an off state (S12).

When the first relay 22 is in the off state, since the first power signal is not provided to the gate of the first transistor M1, the gate of the first transistor M1 enters a floating state, and accordingly, the first transistor M1 may be turned off (S13).

When the first transistor M1 is turned off, the second relay 24 should enter the off state, however, according to the embodiment, the second relay 24 may maintain the on state by the latch signal CTR_LATCH of the enable-level H.

That is, upon receiving the key-off signal (S11), the MCU 163 maintains the enable level H of the latch signal CTR_LATCH during a predetermined period of time from the time point of receiving the key-off signal, and after the predetermined period of time elapses, generates a latch signal CTR_LATCH of a disable level L and outputs the latch signal CTR_LATCH of a disable level L to the gate of the second transistor M2. Therefore, even if the first transistor M1 is turned off according to the key-off signal, the second transistor M2 may maintain the on state during the predetermined period of time in response to the latch signal CTR_LATCH of enable-level H (S14). Accordingly, even if the key-off signal occurs at time T3, the second power signal may be provided to the MCU 163 for a predetermined period of time.

Thereafter, referring to FIGS. 6 and 7, at time T4, when the latch signal CTR_LATCH becomes the disable level L (S15), the second transistor M2 is turned off (S16), current does not flow through the second coil 244 of the second relay 24, and the second switch 242 of the second relay 24 is opened. Accordingly, the second relay 24 enters an off state (S17).

When the second relay 24 is in the off state, the first power signal from the lead-acid battery 26 is not input to the DC-DC converter 165_2, and accordingly, power is not supplied to the LDO circuit 165_3 and the MCU 163. That is, at time T4, the DC-DC converter 165_2, the LDO circuit 165_3, and the MCU 163 are all set to a shutdown mode.

As such, the wake-up apparatus 165 according to the embodiment may set the MCU 163 of the BMS 16 to the shutdown mode, thereby reducing unnecessary power consumption in the MCU 163.

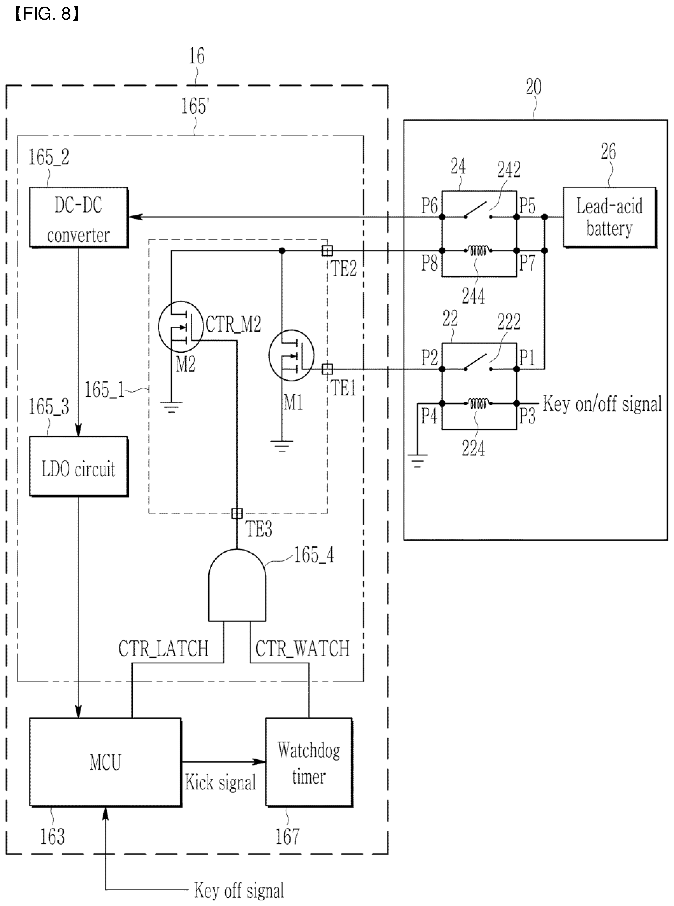

Meanwhile, the MCU 163 of the BMS 16 may get stuck for various reasons. If the MCU 163 suddenly stops, it cannot control the latch signal CTR_LATCH input to the gate of the second transistor M2 even if a key-off signal occurs. Consequently, power continues to be supplied to the MCU 163 even though the MCU 163 is stuck, making it impossible to set it to the shutdown mode. An embodiment that allows the MCU 163 to be set to the shutdown mode even when the MCU 163 is stuck will be described with reference to FIG. 8.

FIG. 8 is a diagram showing a wake-up apparatus according to another embodiment.

Referring to FIG. 8, the BMS 16 may further include a watchdog timer 167.

The watchdog timer 167 periodically monitors the MCU 163, and if it does not receive a kick signal from the MCU 163 within a set period, it may determine that the MCU 163 is in an abnormal state.

According to the embodiment, the watchdog timer 167 may generate an MCU state signal CTR_WATCH having a high level in response to the kick signal received from the MCU 163. In addition, if the kick signal is not received from the MCU 163 within the set period, the watchdog timer 167 may generate an MCU state signal CTR_WATCH having a low level. That is, if the kick signal is received from the MCU 163 within the set period, the MCU state signal CTR_WATCH may continue to have a high level, and if the kick signal is not received from the MCU 163 within the set period, the MCU state signal CTR_WATCH has a low level.

The wake-up apparatus 165' may further include an AND gate 165_4.

The AND gate 165_4 includes two input terminals and one output terminal, and may perform a logical AND operation on signals input to the two input terminals and output a signal corresponding to the operation result through the output terminal.

According to the embodiment, the latch signal CTR_LATCH output from the MCU 163 and the MCU state signal CTR_WATCH output from the watchdog timer 167 may be input to the two input terminals of the AND gate 165_4. The AND gate 165_4 performs a logical AND operation on the latch signal CTR_LATCH and the MCU state signal CTR_WATCH and may output a signal corresponding to the operation result to the output terminal. The output terminal of the AND gate 165_4 may be connected to the gate of the transistor M2, and the output signal CTR_M2 of the AND gate 165_4 may be the signal input to the gate of the transistor M2.

When the MCU 163 is in a normal state, since the MCU state signal CTR_WATCH has a high level, the output signal CTR_M2 input to the gate of the transistor M2 may be determined according to the latch signal CTR_LATCH.

On the other hand, when the MCU 163 is in an abnormal state, since the MCU state signal CTR_WATCH becomes low level, the output signal CTR_M2 has a low level in response to the low level of the MCU state signal CTR_WATCH, and the second transistor M2 may be turned off in response to the low level of the output signal CTR_M2.

In this way, even if the MCU 163 stops due to an abnormal state, the output signal CTR_M2 becomes low level according to the MCU state signal CTR_WATCH, and the transistor M2 may be turned off in response to the output signal CTR_M2 of the low level, whereby the power supply to the MCU 163 may be cut off.

Although the embodiments of the present invention have been described in detail above, the scope of the present invention is not limited thereto, and various modifications and improvements by those skilled in the art using the basic concept of the present invention defined in the following claims also fall within the scope of the present invention.

## Claims

1. A wake-up apparatus for waking up a main control unit (MCU) of a battery management system configured to manage a plurality of battery cells, the wake-up apparatus comprising:
a power supply device configured to receive a first power signal from an auxiliary voltage source used for starting a vehicle through a second relay of the vehicle, and provide a second power signal for an operation of the MCU to the MCU using the first power signal; and
a wake-up control circuit configured to receive the first power signal from the auxiliary voltage source through a first relay of the vehicle in response to a key-on signal of the vehicle, and drive the second relay to an on state in response to the first power signal.

2. The wake-up apparatus of claim 1, wherein
the MCU is configured to generate a latch signal of an enable level in response to an on level of the second power signal, and
the wake-up control circuit is configured to drive the second relay to the on state in response to the latch signal of the enable level.

3. The wake-up apparatus of claim 1, wherein
the MCU is configured to generate a latch signal of a disable level after a set time has elapsed from a time point of receiving a key-off signal of the vehicle, and
the wake-up control circuit is configured to drive the second relay to an off state in response to the latch signal of the disable level.

4. The wake-up apparatus of claim 2, wherein
the first relay includes a first switch having one end connected to the auxiliary voltage source and a first coil, the first coil having one end receiving the key-on signal or key-off signal and another end connected to ground,
the second relay includes a second switch having one end connected to the auxiliary voltage source and a second coil having one end connected to the auxiliary voltage source,
the wake-up control circuit includes a first transistor including a control terminal to which the first power signal is input through the first switch of the first relay, a first terminal connected to ground, and a second terminal connected to another end of the second coil of the second relay, and
the power supply device is configured to connect to another end of the second switch.

5. The wake-up apparatus of claim 4, wherein
the MCU is configured to generate the latch signal of the enable level in response to the on level of the second power signal and generate the latch signal of a disable level after a set time has elapsed from a time point of receiving the key-off signal of the vehicle, and
the wake-up control circuit further comprises a second transistor including a control terminal to which the latch signal is input, a first terminal connected to ground, and a second terminal connected to the another end of the second coil of the second relay.

6. The wake-up apparatus of claim 5, wherein
the wake-up control circuit is configured to drive the second relay to an off state through the second transistor, which is turned off in response to the latch signal of the disable level, and cut off the first power signal provided from the auxiliary voltage source to the power supply device.

7. The wake-up apparatus of claim 1, wherein
the wake-up control circuit is configured to control an on or off state of the second relay based on a signal generated through a logical operation of an MCU state signal output from a watchdog timer that monitors a state of the MCU and a latch signal of an enable level output from the MCU in response to the second power signal.

8. The wake-up apparatus of claim 7, wherein
the MCU periodically transmits a kick signal to the watchdog timer, and
the watchdog timer is configured to generate an MCU state signal of a high level in response to the kick signal received from the MCU, and generate an MCU state signal of a low level if the kick signal is not received from the MCU within a set period.

9. The wake-up apparatus of claim 8, wherein
the MCU is configured to generate a latch signal of a disable level after a set time has elapsed from a time point of receiving a key-off signal of the vehicle.

10. The wake-up apparatus of claim 8, wherein
the logical operation includes a logical AND operation.

11. The wake-up apparatus of claim 8, wherein
the first relay includes a first switch having one end connected to the auxiliary voltage source and a first coil, the first coil having one end receiving the key-on signal or key-off signal and another end connected to ground,
the second relay includes a second switch having one end connected to the auxiliary voltage source and a second coil having one end connected to the auxiliary voltage source,
the wake-up control circuit includes a first transistor including a control terminal to which the first power signal is input through the first switch of the first relay, a first terminal connected to ground, and a second terminal connected to another end of the second coil of the second relay, and
the power supply device is connected to another end of the second switch.

12. The wake-up apparatus of claim 11, wherein
the wake-up control circuit further comprises a second transistor including a control terminal to which a signal generated through the logical operation is input, a first terminal connected to ground, and a second terminal connected to the another end of the second coil of the second relay.

13. A battery system mounted in a vehicle, comprising:
a battery pack including a plurality of battery cells; and
a battery management system configured to manage the battery pack,
wherein the battery management system comprises:
a main control unit (MCU) configured to monitor a state of the plurality of battery cells;
a wake-up control circuit configured to receive a first power signal from an auxiliary voltage source used for starting the vehicle through a first relay of the vehicle in response to a key-on signal of the vehicle to drive a second relay of the vehicle to an on state; and
a power supply device configured to receive the first power signal from the auxiliary voltage source through the second relay, and provide a second power signal for an operation of the MCU to the MCU using the first power signal.

14. The battery system of claim 13, wherein
the MCU is configured to generate a latch signal of an enable level in response to an on level of the second power signal, and
the wake-up control circuit is configured to drive the second relay to the on state in response to the latch signal of the enable level.

15. The battery system of claim 14, wherein
the MCU is configured to generate a latch signal of a disable level after a set time has elapsed from a time point of receiving a key-off signal of the vehicle, and
the wake-up control circuit is configured to drive the second relay to an off state in response to the latch signal of the disable level.

16. The battery system of claim 13, wherein
the battery management system further comprises a watchdog timer configured to receive a kick signal periodically output from the MCU, monitor a state of the MCU based on the received kick signal, and generate an MCU state signal representing the state of the MCU,
the wake-up control circuit is configured to control an on or off state of the second relay through a logical operation of the MCU state signal and a latch signal output from the MCU, and
the MCU is configured to generate a latch signal of an enable level in response to the second power signal.

17. The battery system of claim 16, wherein
the watchdog timer is configured to generate an MCU state signal of a high level in response to the received kick signal, and generate an MCU state signal of a low level if the kick signal is not received from the MCU within a set period, and
the MCU is configured to generate a latch signal of a disable level after a set time has elapsed from a time point of receiving a key-off signal of the vehicle.

18. The battery system of claim 17, wherein
the wake-up control circuit is configured to drive the second relay to an off state in response to the MCU state signal of the low level, and drive the second relay to an off state in response to the latch signal of the disable level when the MCU state signal is at a high level.

19. The battery system of claim 17, wherein
the first relay includes a first switch having one end connected to the auxiliary voltage source and a first coil, the first coil having one end receiving the key-on signal or key-off signal and another end connected to ground,
the second relay includes a second switch having one end connected to the auxiliary voltage source and a second coil having one end connected to the auxiliary voltage source,
the wake-up control circuit includes a first transistor including a control terminal to which the first power signal is input through the first switch of the first relay, a first terminal connected to ground, and a second terminal connected to another end of the second coil of the second relay, and
the power supply device is configured to connect to another end of the second switch.

20. The battery system of claim 19, wherein
the battery management system further comprises an AND gate for performing a logical AND operation on the MCU state signal and the latch signal and outputting a result, and
the wake-up control circuit further comprises a second transistor including a control terminal to which an output signal of the AND gate is input, a first terminal connected to ground, and a second terminal connected to the another end of the second coil of the second relay.
